# EUROPEAN PATENT APPLICATION

(11) **EP 0 741 504 A2**
(43) Date of publication of application: **06.11.1996**
(21) Application number: 96100516.2
(22) Date of filing: 16.01.1996
(51) Int. Cl.: H05K 1/02, H05K 1/05

(54) **Metal core circuit board and method of making**

(30) Priority: 05.05.1995 DE 19516547
(71) Applicant: ROBERT BOSCH GMBH, 70442 Stuttgart (DE)
(72) Inventor: Schupp, Karl, D-75180 Pforzheim (DE); Jares, Peter, Dipl.-Ing., D-71069 Sindelfingen (DE); Karr, Dieter, Dipl.-Phys., D-75233 Tiefenbronn (DE); Harsch, Markus, Dipl-Ing., D-71679 Asperg (DE)

(57) **Zusammenfassung**

Es wird eine Leiterplatte vorgeschlagen, die aus elektrisch und/oder thermisch leitenden Schichten aufgebaut ist, die sich mit isolierenden Schichten abwechseln. Die elektrisch und/oder thermisch leitenden Schichten (4,10) sind miteinander über senkrechte Durchkontaktierungen (6,7,8) elektrisch und/oder thermisch leitend verbunden. Weiterhin sind die innerhalb der Leiterplatte angeordneten elektrisch und/oder thermisch leitenden Schichten mit einem besonders großen Querschnitt versehen, wodurch ein effizienter Wärmetransport in horizontaler Richtung der Leiterplatte ermöglicht wird.

## Description

### Stand der Technik

Die Erfindung geht aus von einer Leiterplatte nach der Gattung des Hauptanspruches. Es ist von der Firma Fuba, "Fuba Aktuell", 1/89, Seite 6, eine Leiterplatte mit einem Metallkern als leitende Schicht bekannt. Der Metallkern weist eine Dicke von 300 µm bis zu 1200 µm auf und ist mit elektrisch isolierten Durchkontaktierungen versehen. Der Metallkern ist auf seiner Ober- und Unterseite mit jeweils einer Isolierschicht bedeckt. Die Herstellung der Leiterplatte ist verhältnismäßig aufwendig, da für jede Durchkontaktierung ein Loch in den Metallkern gebohrt werden muß.

### Vorteile der Erfindung

Die erfindungsgemäße Leiterplatte mit den Merkmalen des Hauptanspruchs hat demgegenüber den Vorteil, daß die leitende Schicht und das erfindungsgemäße Verfahren zur Herstellung der Leiterplatte nach Anspruch 6 haben demgegenüber den Vorteil, daß mithilfe eines Ätzverfahrens Löcher für die Durchkontaktierungen in die als leitende Schicht ausgebildete dritte Schicht eingebracht werden. Dieses Verfahren ist einfach auszuführen und besonders kostengünstig. Auf diese Weise können Löcher in beliebiger Form in die dritte Schicht eingebracht werden. Damit kann die Form der Löcher und damit die Form der Durchkontaktierungen der erforderlichen Wärmeableitung angepaßt werden. Somit ist es auf kostengünstige Weise möglich, eine Leiterplatte mit einem Metallkern, der zur Wärmeableitung verwendet wird, herzustellen.

Durch die in den Unteransprüchen aufgeführten Maßnahmen sind vorteilhafte Weiterbildungen und Verbesserungen der im Hauptanspruch angegebenen Leiterplatte und des im Anspruch 6 angegebenen Verfahrens zur Herstellung der Leiterplatte möglich. Die dritte Schicht weist vorzugsweise eine Dicke von maximal 200 µm auf. Bei einer Dicke bis zu 200 µm kann die dritte Schicht noch mittels Ätzverfahren einfach und kostengünstig hergestellt werden und ist gleichzeitig für eine Wärmeabfuhr ausreichend dick ausgebildet.

Die Wärmeableitung wird verbessert, indem auf der ersten und zweiten Isolationsschicht eine erste und/oder eine zweite Leiterstruktur aufgebracht ist, die auch Wärme leitet. Dadurch wird ein Transport der Wärme in seitlicher Richtung verbessert.

Eine bevorzugte Ausführung der Leiterplatte besteht darin, eine vierte thermisch leitende Schicht anzuordnen. Diese Ausführung stellt eine optimierte Leiterplatte in Bezug auf den Herstellungsaufwand und der damit erreichten Wärmeleitung der Leiterplatte dar. Außerdem können die erste und die zweite Leiterstruktur mithilfe der dritten und der vierten Schicht auf unterschiedliche elektrische Potentiale gelegt werden.

Eine Verbesserung der Wärmeleitung in senkrechter Richtung wird erreicht, indem die erste und die zweite Leiterstruktur und die dritte und/oder die vierte Schicht über mindestens eine Durchkontaktierung thermisch und/oder elektrisch miteinander verbunden sind.

### Zeichnung

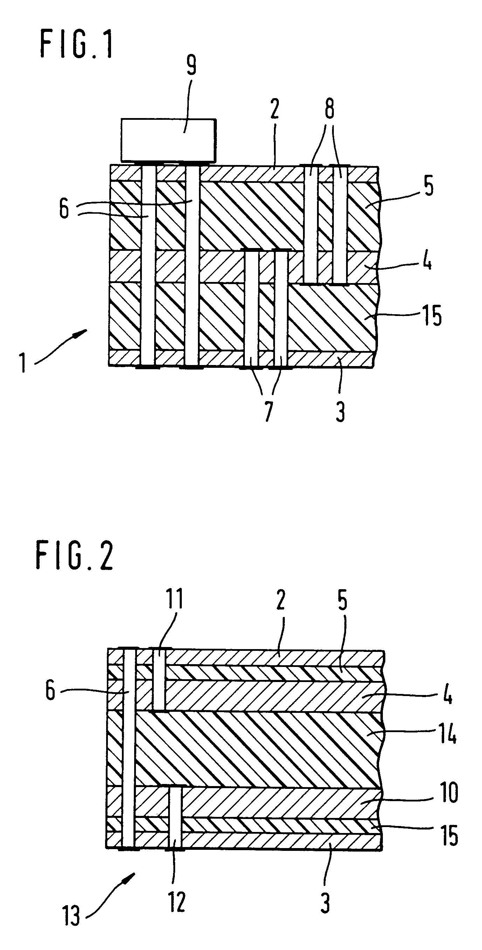

Ein Ausführungsbeispiel der Erfindung ist in der Zeichnung dargestellt und in der nachfolgenden Beschreibung näher erläutert. Es zeigen Figur 1 eine Leiterplatte mit einem Leistungsbauelement und Figur 2 eine besondere Ausführung der Leiterplatte.

### Beschreibung der Ausführungsbeispiele

Figur 1 zeigt eine Leiterplatte 1, auf deren Oberseite eine erste Leiterstruktur 2 angeordnet ist. Die Leiterstruktur 2 weist mindestens eine elektrische Leitung auf, die zur elektrischen Kontaktierung des Leistungsbauelementes oder weiterer nicht dargestellter elektrische Bausteine verwendet wird. Unter der ersten Leiterstruktur 2 ist eine erste Isolationsschicht 5 eingebracht. Nach der ersten Isolationsschicht 5 folgt eine dritte Schicht 4, die ebenfalls elektrisch und thermisch leitend ist. Auf die dritte Schicht 4 folgt eine zweite Isolationsschicht 15. Auf die Isolationsschicht 15 ist eine zweite Leiterstruktur 3 aufgebracht.

Die erste Leiterstruktur 2 ist über zwei durchgehende erste Durchkontaktierungen 6 mit der zweiten Leiterstruktur 3 und der dritten Schicht 4 elektrisch und thermisch leitend verbunden. In einer einfachen Ausführung reicht eine erste Durchkontaktierung 6 aus. Über den Verbindungsstellen der ersten Durchkontaktierungen 6 mit der ersten Leiterstruktur 2 ist ein Leistungsbauelement 9 aufgebracht.

Weiterhin ist die erste Leiterstruktur 2 vorzugsweise über z.B. zwei parallele zweite Durchkontaktierungen 8 mit der dritten Schicht 4 elektrisch und thermisch leitend verbunden. Die dritte Schicht 4 ist vorzugsweise über z.B. zwei parallele dritte Durchkontaktierungen 7 mit der zweiten Leiterstruktur 3 elektrisch und thermisch leitend verbunden. Die dritte Schicht 4 befindet sich in der Mitte der Leiterplatte 1 und weist im Vergleich zu der ersten und der zweiten Leiterstruktur 2, 3 einen größeren Querschnitt auf. Die erste, zweite Leiterstruktur und die dritte Schicht 2, 3, 4 sind beispielsweise aus Kupfer gebildet. Die erste und zweite Isolationsschicht 5,15 bestehen aus Leiterplattenmaterial.

Die erste und die zweite Leiterstruktur 2,3 weisen vorzugsweise eine Dicke von 30µm, die erste und die zweite Isolationsschicht 5, 15 eine Dicke von 85µm, die dritte Schicht 4, die den Metallkern darstellt, weist vorzugsweise eine Dicke von bis zu 200 µm auf.

Da die dritte Schicht 4 nur eine Dicke von bis zu 200 µm aufweist, können die Löcher für die Durchkontaktierungen mithilfe fotolithographischer Verfahren und mithilfe von Ätzverfahren in die dritte Schicht 4 eingebracht werden. Bis zu einer Dicke der dritten Schicht von 200µm reicht ein einseitiges Ätzverfahren aus. In Leiterplatten, die einen besonders hohen Wärmetransport ermöglichen sollen, wird die dritte Schicht 4 in einer Dicke von 200µm bis zu 400µm ausgebildet. Bei einer Schichtdicke von 200 µm bis zu 400 µm werden zum Einbringen der Löcher zweiseitige Ätzverfahren eingesetzt. Die Löcher für die Durchkontaktierungen weisen vorzugsweise einen Durchmesser von 0,3 bis 0,6 mm auf. Aus den geätzten Schichten 4 werden mit bekannten Verfahren Leiterplatten hergestellt. Der Vorteil der geringen Schichtdicken von bis zu 100 µm bis 200µm bzw. von 200µm bis zu 400µm besteht darin, daß die Schichtdicken einen ausreichenden Wärmetransport zur Kühlung von Bauelementen ermöglichen und die Löcher für die Durchkontaktierungen in die Schichten mittels einfacher Ätzverfahren eingebracht werden.

Die Anordnung nach Figur 1 funktioniert wie folgt:

Über die ersten, zweiten und dritten Durchkontaktierungen 6, 8, 7 wird Wärme, die vom Leistungsbauelement 9 erzeugt wird, von der Oberseite der Leiterplatte 1 auf die dritte Schicht 4 und auf die zweite Leiterstruktur 3 geleitet. Auf diese Weise erfolgt ein schneller Wärmetransport von der Oberseite zur Unterseite der Leiterplatte 1. Da die dritte Schicht 4 einen großen Querschnitt aufweist, findet ein guter Wärmetransport auch in vertikaler Richtung in der Leiterplatte 1 statt. Damit wird die auf der Oberfläche der Leiterplatte 1 entstehende Wärme möglichst gleichmäßig über die gesamte Leiterplattenfläche verteilt und punktuell hohe Temperaturen am Leistungsbauelement vermieden.

Figur 2 zeigt eine weitere Leiterplatte 13, die auf der Oberseite die erste Leiterstruktur 2 und auf der Unterseite die zweite Leiterstruktur 3 aufweist. Unter der ersten Leiterstruktur 2 ist die erste Isolationsschicht 5 angeordnet. Auf die erste Isolationsschicht 5 folgt die dritte Schicht 4. Die dritte Schicht 4 weist eine Dicke von bis zu 200µm auf. Auf die dritte Schicht 4 folgt eine breit ausgebildete dritte Isolationsschicht 14. Die Dicken der Schichten entsprechen den Dicken der Schichten der Figur 1.

An die dritte Isolationsschicht 14 schließt sich eine elektrisch und thermisch leitende vierte Schicht 10 an. Die vierte Schicht 10 ist über eine zweite Isolationsschicht 15 von der zweiten Leiterstruktur 3 getrennt. Die vierte Schicht 10 weist eine Dicke von bis zu 200 µm auf und ist in Analogie zur dritten Schicht 4 aufgebaut. Die erste Durchkontaktierung 6 verbindet die erste und die zweite Leiterstruktur 2,3 und die dritte und die vierte Schicht 4,10 elektrisch und thermisch leitend miteinander.

Für spezielle Anwendungen sind die erste und die zweite Leiterstruktur 2, 3 voneinander elektrisch isoliert, wobei die erste Durchkontaktierung 6 elektrisch gegen die erste und die zweite Leiterstruktur 2, 3 isoliert ist.

Eine vierte Durchkontaktierung 11 verbindet die erste Leiterstruktur 2 mit der dritten Schicht 4. Eine fünfte Durchkontaktierung 12 verbindet die vierte Schicht 10 mit der zweiten Leiterstruktur 3. Die Durchkontaktierungen bestehen beispielsweise aus Kupfer oder Lotzinn. Da die erste und zweite Isolationsschichten 5,15 besonders dünn sind, erfolgt ein zusätzlich guter Wärmetransport von der ersten Leiterstruktur 2 auf die dritte Schicht 4 bzw. von der vierten Schicht 10 zur zweiten Leiterstruktur 3.

Durch die Anordnung der dritten Schicht 4 und der vierten Schicht 10 und die thermische Anbindung der dritten Schicht 4 und der vierten Schicht 10 an das Leistungsbauelement wird ein effizienter Wärmetransport in horizontaler Richtung innerhalb der Leiterplatte 13 ermöglicht. Die dritte und vierte Schicht 4,10 sind beispielsweise aus Kupfer gebildet.

Die Leiterplatte nach Figur 2 weist zwei thermisch und elektrisch leitende Schichten in Form der dritten und vierten Schicht 4,10 auf. Durch eine elektrische Trennung der dritten Schicht 4 von der vierten Schicht 10 und eine elektrische Anbindung der dritten Schicht 4 an die erste Leiterstruktur 2 und der vierten Schicht 10 an die zweite Leiterstruktur 3 ist es möglich, die Leiterstrukturen 2,3 auf unterschiedlichem elektrischen Potential zu halten.

Auf diese Weise können Bausteine, die an die erste oder zweite Leiterstruktur 2,3 angeschlossen sind, auf unterschiedlichem Potential gehalten werden. Dies ist von Vorteil bei der Verwendung von Bauelementen, deren Arbeitsbereiche an unterschiedliche elektrische Potentiale angepaßt sind. Da die dritte und die vierte Schicht 4,10 elektrisch leitend sind, können diese außer als Wärmeleiter auch als Abschirmungen dienen.

Die in den Figuren 1 und 2 dargestellten Leiterplatten 1 und 13 bieten die Möglichkeit, Leistungsbauelemente und andere Bauelemente nur nach schaltungstechnischen Gesichtspunkten optimal auf der Leiterplatte anzuordnen, da ein Wärmetransport nicht nur in senkrechter Richtung, sondern auch in vertikaler Richtung innerhalb der Leiterplatte stattfindet, und somit eine gute Verteilung der Wärme gewährleistet ist.

## Patentansprüche

1. Leiterplatte (1, 13) mit einer in der Leiterplatte angeordneten elektrisch leitenden dritten Schicht (4), die auf der Ober- und Unterseite von einer ersten und von einer zweiten Isolationsschicht (5,15) bedeckt ist, wobei durch die dritte Schicht (4) elektrisch leitende Durchkontaktierungen (6,7,8) von der Oberseite zur Unterseite der Leiterplatte (1,13) geführt sind, dadurch gekennzeichnet, daß in die dritte Schicht (4) Löcher für die Durchkontaktierungen mittels Ätzverfahren eingebracht sind.

2. Leiterplatte nach Anspruch 1, dadurch gekennzeichnet, daß die dritte Schicht (4) eine Dicke aufweist, die kleiner als 200µm ist.

3. Leiterplatte nach einem der Ansprüche 1 und 2, dadurch gekennzeichnet, daß auf der ersten Isolationsschicht (5) eine erste Leiterstruktur (2) aufgebracht ist, und daß auf der zweiten Isolationsschicht (15) eine zweite Leiterstruktur (3) aufgebracht ist.

4. Leiterplatte nach Anspruch (3), dadurch gekennzeichnet, daß eine dritte Isolationsschicht (14) auf der Unterseite der dritten Schicht (4) aufgebracht ist, und daß auf der dritten Isolationsschicht (14) eine vierte Schicht (10) aufgebracht ist.

5. Leiterplatte nach einem der Ansprüche 1 bis 4, dadurch gekennzeichnet, daß die erste und die zweite Leiterstruktur (2,3) und die dritte und/oder die vierte Schicht (4,10) über mindestens eine Durchkontaktierung (6, 7, 8, 11, 12) thermisch und/oder elektrisch miteinander verbunden sind.

6. Verfahren zur Herstellung einer Leiterplatte mit einer elektrisch und thermisch leitenden Schicht mit Durchkontaktierungen, wobei in die thermisch leitende Schicht Löcher eingebracht werden, dadurch gekennzeichnet, daß die Löcher in die elektrisch und thermisch leitende Schicht mittels fotolithographischer Verfahren und Ätzverfahren eingebracht werden.
